(19) Europäisches Patentamt
European Patent Office
Office européen des brevets

(11) **EP 2 403 167 B1**

(12) **EUROPEAN PATENT SPECIFICATION**

(45) Date of publication and mention
of the grant of the patent:
**10.10.2012 Bulletin 2012/41**

(51) Int Cl.:
***H04B 10/158*** (2006.01)    ***H03M 13/15*** (2006.01)
***H04L 1/00*** (2006.01)

(21) Application number: **10290356.4**

(22) Date of filing: **30.06.2010**

(54) **Method of transmitting data via an optical transmission channel**

Verfahren zur Übertragung von Daten über einen optischen Übertragungskanal

Procédé de transmission de données via un canal de transmission optique

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(43) Date of publication of application:
**04.01.2012 Bulletin 2012/01**

(73) Proprietor: **Alcatel Lucent**
**75007 Paris (FR)**

(72) Inventor: **Leven, Andreas**
**74321 Bietigheim-Bissingen (DE)**

(74) Representative: **Urlichs, Stefan et al**
**Alcatel Lucent**
**Intellectual Property & Corporate Standards**
**Lorenzstrasse 10**
**70435 Stuttgart (DE)**

(56) References cited:
**EP-A2- 0 777 354    US-A- 3 891 959**
**US-A- 4 035 767    US-A1- 2004 081 247**

## Description

### Field of the invention

The invention relates to a method of transmitting data via an optical transmission channel.

### Background

When transmitting data via an optical transmission channel by means of a phase modulated signal, the received signal may be degraded due to phase disturbances caused by the transmission channel or device elements of the sender or the receiver. Such phase disturbances have to be compensated at the receiving side.

### Summary

Proposed is a method of transmitting data via an optical transmission channel.

The method comprises different steps.

An input information word is generated, by differentially encoding an input bit sequence. An input code word is generated, by applying a systematic, linear, cyclic block code to the input information word.

The input code word is modulated onto an optical carrier signal using a phase-shift keying modulation scheme. Then, the modulated signal is transmitted via an optical transmission channel and received at a receiving side. At the receiving side, a received code word is derived from the received signal.

A first decoded information word and a first number of detected errors (NE1) are generated, by applying to the received code word a decoding algorithm that is suitable for the used block code.

Using the received code word, a modified code word is generated, by a cyclic shift of the received code word and an addition of the said cyclically shifted code word and the said received code word.

Then, an intermediate information word and a second number of detected errors are generated, by applying to the modified code word a decoding algorithm that is suitable for the used block code.

A second decoded information word is generated, using the intermediate information word. The second decoded information word is generated by computing a cumulative sum of the intermediate information word.

One of the first or the second decoded information words is chosen, using a criterion that is derived from the numbers of detected errors.

Finally, an output bit sequence is (OBS) generated, by differentially decoding the chosen decoded information word.

### Brief description of the drawings

Figure 1 shows a block diagram illustrating a method of data transmission including forward error correction.

Figure 2 shows different phase modulated signals within a complex plane.

Figure 3 shows a block diagram illustrating a method of data transmission including forward error correction as well as differential encoding and differential decoding.

Figures 4 show a block diagram illustrating the step of differential encoding.

Figures 5 show a block diagram illustrating the step of differential decoding.

Figure 6 shows different signals occurring when applying differential encoding and differential decoding in case of no phase disturbances.

Figure 7 shows different signals occurring when applying differential encoding and differential decoding in case of a persistent phase slip.

Figure 8 shows different signals occurring when applying differential encoding and differential decoding in case of two single phase errors occurring at non consecutive samples.

Figure 9 shows a difference of a signal to noise ratio required for compensating for increased error rates when applying differential encoding and differential decoding.

Figure 10 shows a block diagram illustrating the proposed method according to a first embodiment.

Figure 11 shows different code words and different information words in case of a persistent phase slip and in case of no phase disturbances.

Figure 12 shows different code words in case of phase errors and bit errors occurring at non consecutive samples.

Figure 13 shows a block diagram illustrating the proposed method according to a second embodiment.

Figure 14 shows an information word yielded by a concatenation of differentially encoded bits and a pilot sequence.

Figure 15 shows different bit error rates achieved by different transmission methods.

Figure 16 shows a receiving device according to an embodiment.

Figure 17 shows a receiving device according to an alternative solution.

**Description of embodiments**

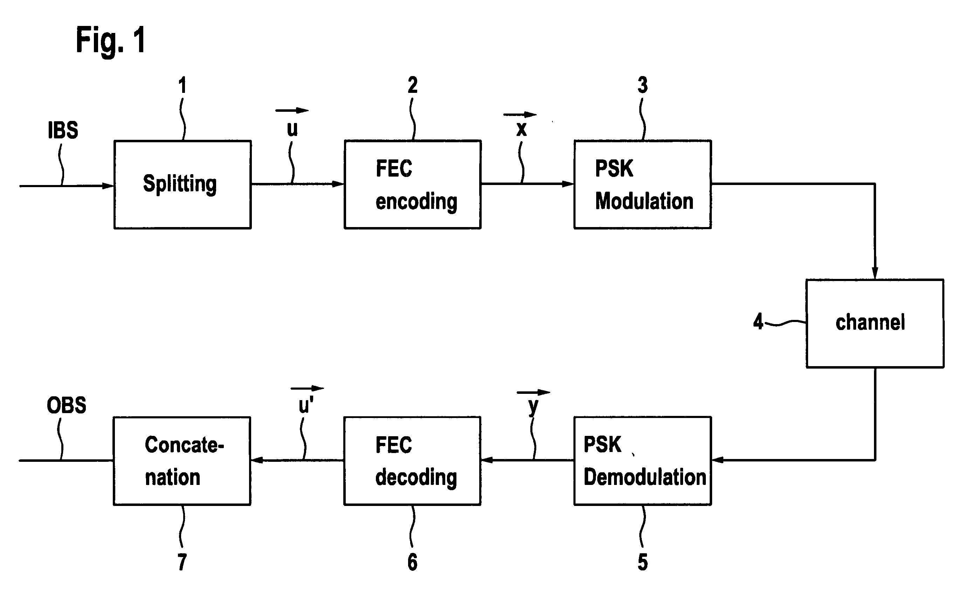

Figure 1 shows a block diagram of different steps carried out for transmitting data via o phase modulated signal according to the prior art.

An input bit stream or an input bit sequence IBS is to be transmitted via a transmission channel. Within a splitting step 1, the input bit sequence IBS is split into sets of k consecutive bits, each set of consecutive bits forming an information word $\bar{u} = [u_1, ..., u_k]$. For the purpose of forward error correction encoding, a code word $\bar{x}$ is generated by multiplying the information word $\bar{u}$ by a generator matrix $G$ of a block code within a forward error correction (FEC) encoding step 2 as

$$\bar{x} = \bar{u} \cdot \underline{\underline{G}}.$$

The generator matrix $G$ contains $n$ columns and $k$ rows

$$\underline{\underline{G}} = \begin{pmatrix} & \\ & \\ & \end{pmatrix}^n ,$$

thus generating a code word $\bar{x}$ of the length $n$, wherein $n$ is greater than $k$.

In a modulation step 3, the code word $\bar{x}$ is modulated onto a carrier signal using a phase shift keying modulation scheme. Then, the modulated signal is transmitted via a transmission channel 4. On the receiving side, the transmitted signal is received and demodulated in a demodulation step 5, for deriving from the received signal a received code word $\bar{y}$.

The received code word $\bar{y}$ is decoded, using a decoding algorithm that is suitable for the block code previosuly used for forward error correction encoding, in order to generate the decoded information word $\bar{u}'$ of length $k$. Such a decoding algorithm may be on algorithm of Maximum Likelihood Decoding, Minimum Distance Decoding or any other suitable decoding algorithm. Consecutive received decoded information words $\bar{u}'$ are then concatenated in a concatenation step 7, for generating an output bit stream OBS.

Due to phase disturbances occurring during the signal transmission, some of the bits of the received code word $\bar{y}$ may be erroneous. A distortion of the phase can be caused by different effects. A first effect is Gaussian noise caused by amplifying components of a sending device or a receiving device. A second effect is a noise caused by a local oscillator of the sender or the receiver, due to the local oscillator not being exactly at the desired. A further effect is noise caused by the transmission channel.

Depending on the used block code and the occurring number of erroneous bits within the received code word $\bar{y}$, the decoding algorithm is able to detect a certain number of erroneous bits within the received code word $\bar{y}$ and also

to correct a certain number of erroneous bits within the received code word $\bar{y}$. The abilities of error detection and error correction depend on the dimensioning of the block code.

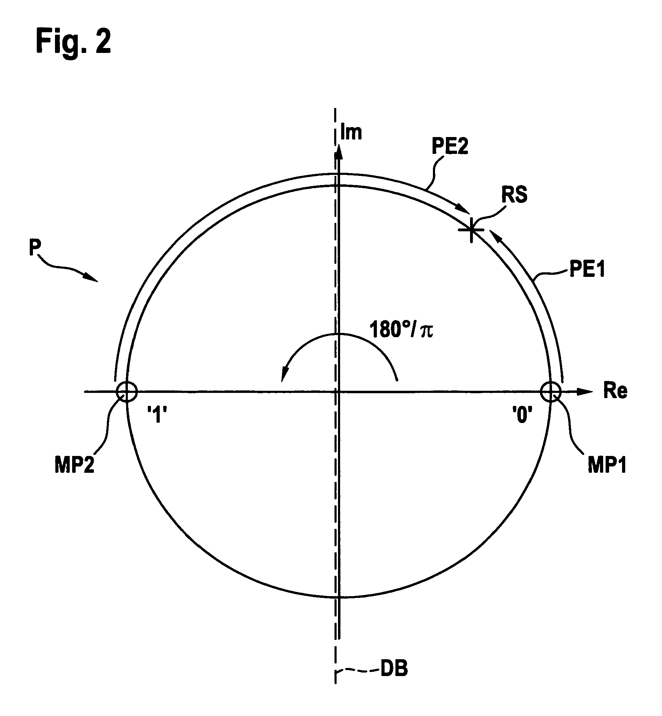

Figure 2 shows a constellation diagram of a phase shift keying modulation scheme within a complex plane P. The real axis Re and the imaginary axis Im are depicted. One constellation point MP1 represents a signal with the phase of 0 degrees, while another constellation point MP2 represents a signal of the same amplitude, but with a phase differing by 180 degrees from the signal of the constellation point MP1. For transmitting a bit of the value '0', the signal that is equivalent to the constellation point MP1 is transmitted. For transmitting a bit of the value '1', the signal equivalent to the constellation point MP2 is transmitted. On the receiving side, the phase of the received signal is analysed and interpreted for generating the received code word $\bar{y}$.

The phase of a received signal RS, shown in Figure 2, is compared to the phases of the constellation points MP1, MP2, for deciding and detecting whether a '0' or a '1' has been transmitted. The received signal RS is associated with that constellation point MP1, whose phase is most similar to that of the received signal RS. This detection scheme uses a decision border DB, which splits the complex plane P into equivalent parts. This detection scheme is also known as a hard decision detection.

A problem occurs in the case, that the assumption that the phase error is equal to PE1 is wrong. It may be the case, that a '1' has been transmitted via a signal equivalent to the constellation point MP2, and that the phase error actually is equal to the phase error PE2. Thus, when applying a hard decision detection scheme to the received signal, a wrong decision is made at the reception side, due to the phase error PE2 being larger than half of the phase difference between the constellation points MP1 and MP2. Such a phase error PE2 leads to a wrong decision and an inverted bit sample for that time instance for which this phase error PE2 occurs, when applying a hard decision detection scheme. If the phase error PE2 occurs only for that amount of time during which a single sample bit is received and thus inverted, the phase error is called a single phase error. If this phase errors PE2 persists for an extended amount of time, also the following bit samples received during the persistency of the phase error are inverted. Such a persistent phase error PE2 are is called a phase slip. This leads to a high bit error rate of a received code word $\bar{y}$, in which case the decoding algorithm may not be able any more to detect and to correct all errors within the received code word $\bar{y}$. This leads to a decoded information word $\bar{u}'$ different to the original information word $\bar{u}$.

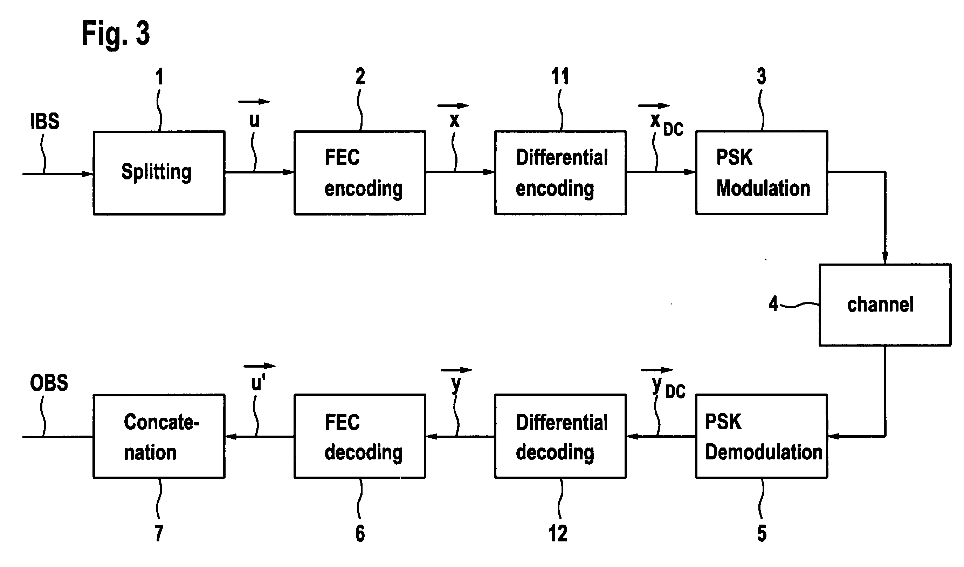

A common technique for compensating the effect of a phase slip is known as differential encoding and differential decoding, for which the block diagram shown in Figure 3 illustrates the different steps. Figure 3 shows all steps which are shown in Figure 1. Furthermore, Figure 3 shows a step of differential encoding 11, which is placed between the steps of forward error correction encoding 2 and the modulation step 3. Even furthermore, Figure 3 shows a step of differential decoding 12, which is placed between the step of demodulation 5 and the step of forward error correction decoding 6.

At the step of differential encoding 11, the bits of consecutive code words $\bar{x}$ are differentially encoded by a transfer function described in the z-domain as

$$H_{ENC}(z) = \frac{1}{1 - z^{-1}} \quad ,$$

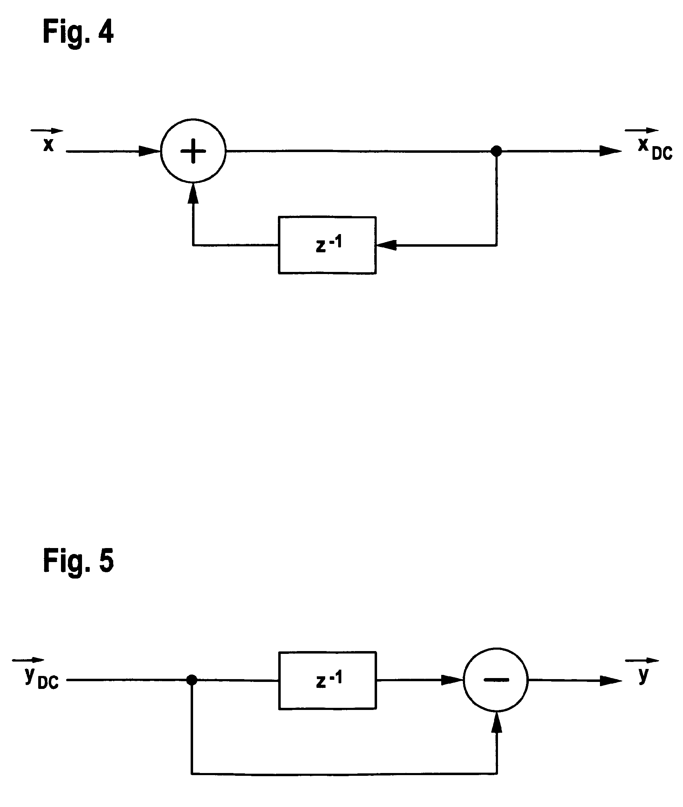

for which a corresponding block diagram is depicted in Figure 4. The resulting differentially encoded code word $\bar{x}_{DC} = [x_{DC}(1),...,x_{DC}(k)]$ for binary values can be described in the time domain by the equation

$$x_{DC}(i) = x(i) \oplus x_{DC}(i-1) \quad ,$$

with $i$ as the index $i = 1,...,k$. The operator $\oplus$ indicates a modulo-2 addition which is used for binary values. On the receiving side at the step of differential decoding 12, the received and differentially coded code word $\bar{y}_{DC}$ is decoded by the transfer function described in the z-domain as

$$H_{DEC}(z) = 1 - z^{-1} \quad ,$$

for which a block diagram is shown in Figure 5. The resulting differentially decoded code word $\bar{y} = [(y(1),..., y(k)]$ for binary values is then given in the time-domain by the equation

$$y(i) = y_{DC}(i) \oplus y_{DC}(i-1).$$

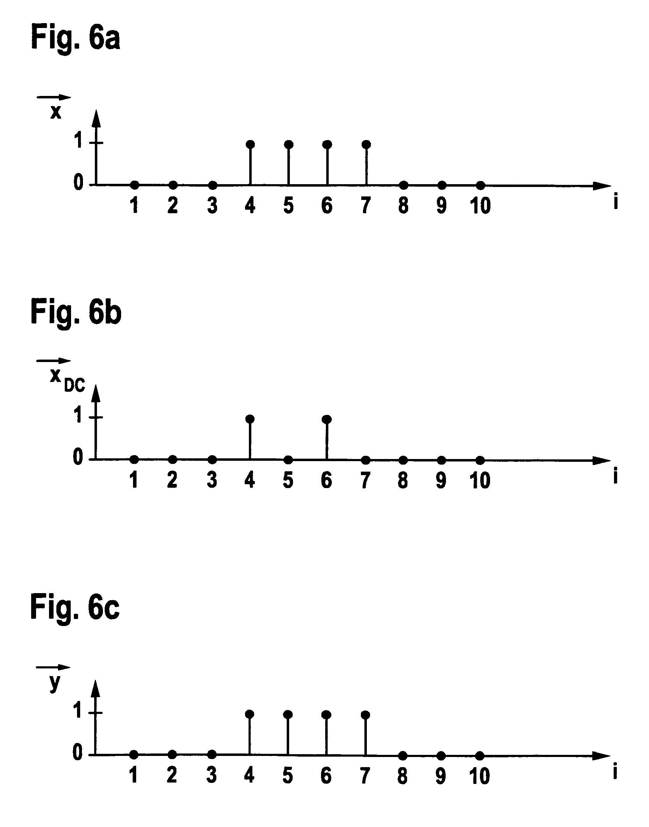

The effect of transferring a differentially coded code word is illustrated in the following by the different bit sequences shwon in the Figures 6, 7 and 8. Figure 6a illustrates an example of a code word $\bar{x}$ that is to be transmitted. Figure 6b shows a differentially encoded code word $\bar{x}_{DC}$. Comparing the original code word $\bar{x}$ and the differentially encoded code word $\bar{x}_{DC}$, one can clearly see that at each time instance at which the original code word $\bar{x}$ contains a bit of the value '1', the differentially encoded code word $\bar{x}_{DC}$ contains a bit, which is different to its preceding bit. Transferring this differentially encoded code word $\bar{x}_{DC}$ using a modulation scheme as shown in Figure 2, the result is that for each sample where the original code word $\bar{x}$ contains a '1', the differentially encoded code word $\bar{x}_{DC}$ causes a change of the phase angle. For each sample at which the original code word $\bar{x}$ contains a '0', the phase of the transmission signal caused by the code word $\bar{x}_{DC}$ is maintained. If no transmission error occurs, then the received differentially encoded code word $\bar{y}_{DC}$ is equal to the code word $\bar{x}_{CD}$. The code word $\bar{y}$ resulting from differentially decoding the received code word $\bar{y}_{DC}$ is shown in Figure 6c.

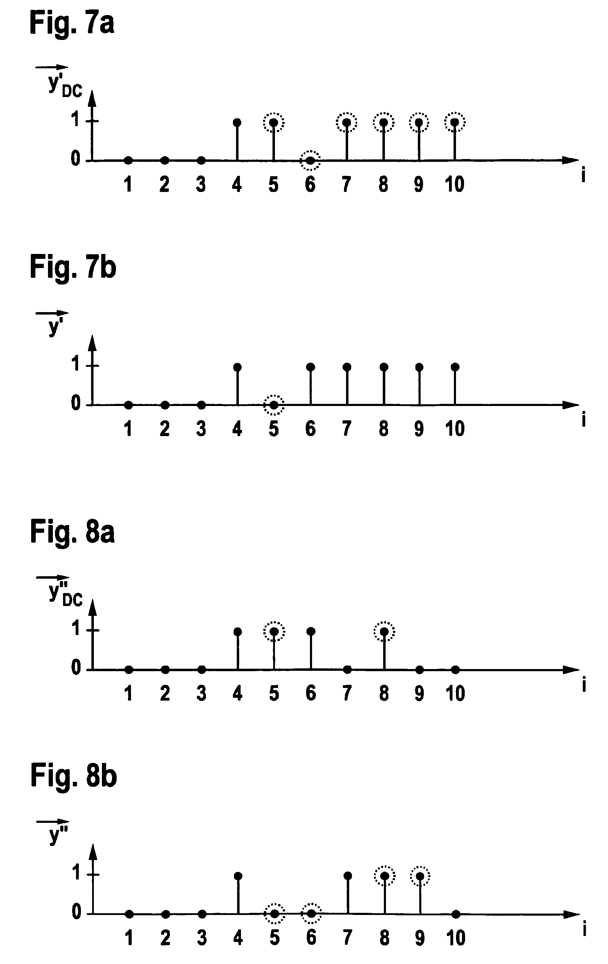

The effect of a persistent phase slip starting at the fifth sample for a received differentially encoded code word $\bar{y}'_{IX}$ is shown in Figure 7a. Due to the phase slip, the fifth sample and all consecutive samples thereafter are inverted. Looking at the differentially decoded code word $\bar{y}'$ in Figure 7b, one can see that in comparison to the original code word $\bar{x}$ of Figure 6a, only the fifth bit has been affected by the phase slip, while all consecutive bits maintain unchanged.

Figure 8a shows a differentially encoded received code word $\bar{y}''DC$, affected by two single bit errors occuring at the fifth and the eighth bit. The resulting differentially decoded code word $\bar{y}''$, shown in Figure 8b, shows in comparison to the correct code word $\bar{x}$ of Figure 6a four bit errors, at the fifth, the sixth, the eighth and the ninth sample. Thus, two single inverted bits of a differentially encoded code word cause four bit errors of the differentially decoded code word. This disadvantageous effect is known as error multiplication, which is caused by differential coding in case of single errors occurring at non consecutive samples.

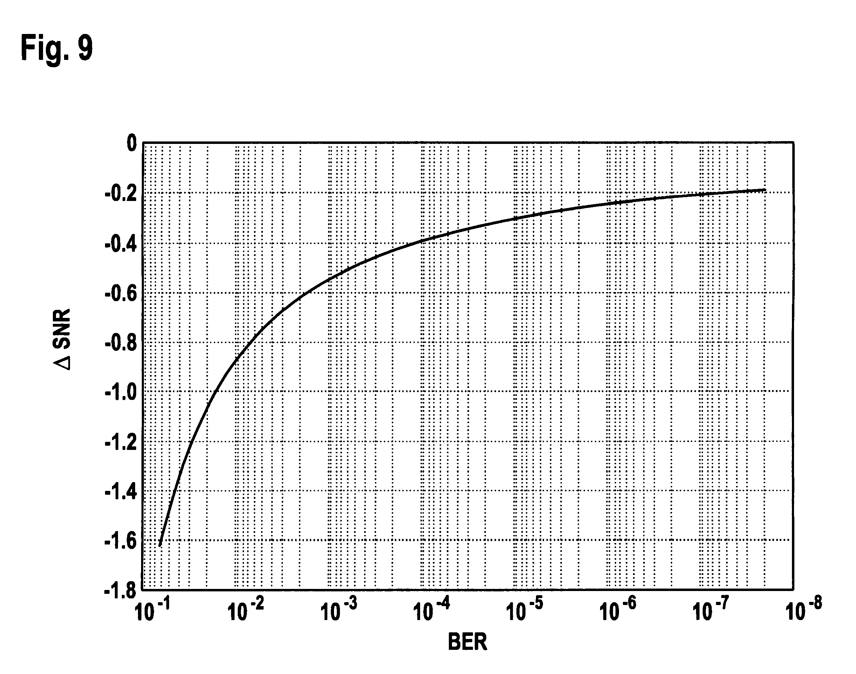

The effect of error multiplication approximately doubles the bit error rate for a signal to noise ratio (SNR) at which single bit errors ore much more likely to occur than phase slips. Therefore, when relying on differential coding for transmitting data via transmission channels with such a signal to noise ratio, the required signal to noise ratio has to be higher than when not relying on differential coding. This difference between the optical signal to noise ratios required for achieving the same bit error rate for both transmission methods is called a signal to noise ratio penalty. This penalty ΔSNR is illustrated in Figure 9 in comparison to a bit error rate BER.

For current optical transmissions systems, the bit error rate that has to be achieved at the receiving side is approximately 1e-13.

When combining the transmission system shown in Figure 3 with an additional Forward Error Correction, this is equivalent to achieving a bit error rate by the transmission system of Figure 3 of approximately 1e-3. It is an aim of the proposed method to further improve the known method of data transmission.

**First embodiment of the proposed method**

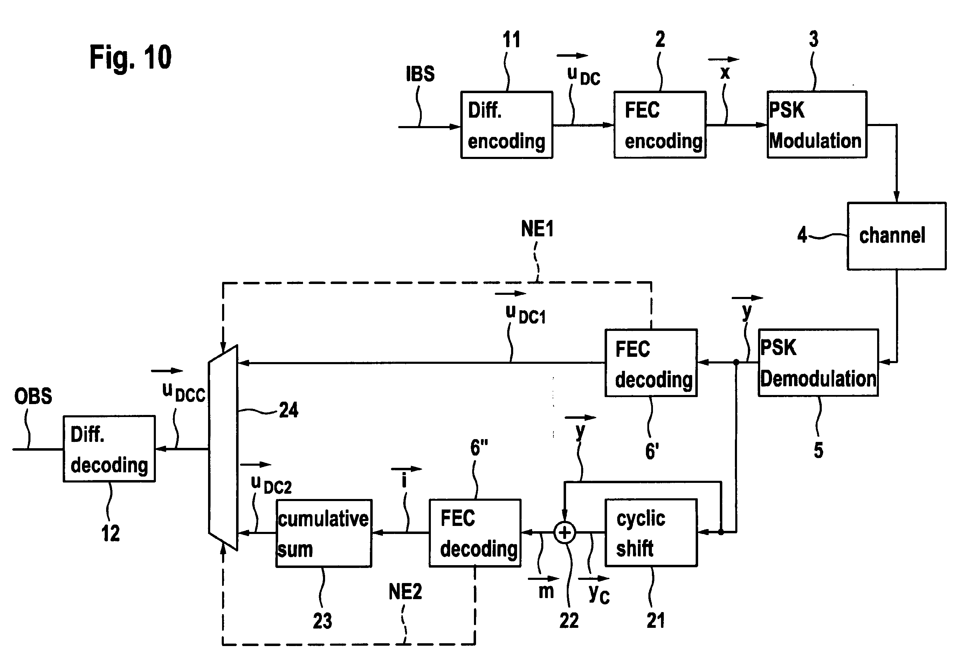

Figure 10 shows a block diagram illustrating the first embodiment of the proposed method. An input stream IBS is differentially encoded in a step of differential encoding 11, and a consecutive number of differentially encoded bits is chosen for forming an information word $\bar{u}_{DC}$. In a forward error correction encoding step 2, a code word $\bar{x}$ is generated, by applying a systematic, linear, cyclic block code to the information word $\bar{u}_{DC}$. Preferably, the block code is a systematic, linear, cyclic Bose-Chaudhuri-Hocquenghem (BCH) Code. The property 'linear' imposes, that any code word of the block code added to any other code word of the block code yields a valid code word of that block code. The property 'cyclic' imposes, that a cyclic shift of a code word yields another valid code word. The property 'systematic' imposes, that the information word $\bar{u}_{DC}$ is contained unchanged within the code word $\bar{x}$, and that the systematic block code only adds further redundancy bits to the original information word $\bar{u}_{DC}$. Thus, the code word $\bar{x}$ con be written as $\bar{x}$ =$[u_{DC}(1),...,u_{DC}(k),x(k+1),...,x(n)]$.

During a modulation step 3, the code word $\bar{x}$ is modulated onto an optical carrier signal using a binary phase shift keying (BPSK) modulation scheme as previously described above. The phase modulated signal is then transmitted via on optical transmission channel 4 and received on the receiving side. Within a demodulation step 5, a received code word $\bar{y}$ is derived from the received signal, by applying a hard decision detection scheme.

On the receiving side, two decoded information words $\bar{u}_{DC1}$, $\bar{u}_{DC2}$ are generated, and one of these decoded information words is then chosen in a selection step 24 as the information word $\bar{u}_{DCC}$, which then is differentially decoded in a step of differential decoding 12, for generating an output bit sequence OBS.

The different steps of generating the information words $\bar{u}_{DC1}$, $\bar{u}_{DC2}$, $\bar{u}_{DCC}$ and the advantages of this method over the prior art will be explained in detail further on. Using a decoding algorithm that is suitable to the block code used for forward error correction, the received code word $\bar{y}$ is decoded for generating the information word $\bar{u}_{DC1}$ within a forward error correction decoding step 6'. Preferably, the decoding algorithm is a Berlekamp-Massey Algorithm or a Welch-Berlekamp Algorithm, which are suitable for a BCH code.

The decoding algorithm is able to correct a certain number of errors. Having yielded the decoded information word $\bar{u}_{DC1}$, which is of the length $k$, the first $k$ bits of the received code word $\bar{y}$ can compared to the k bits of the information word $\bar{u}_{DC1}$ for obtaining the number of corrected samples, since the block code is a systematic block code. The error word, $\bar{e}_1$ is then given as $\bar{e}_1 = \bar{u}_{DC1} \oplus [y(1),...,y(k)]$. Thus, the decoding algorithm provides a number of corrected bits NE1 while generating the information word $\bar{u}_{DC1}$.

In parallel to the steps carried out for yielding the information word $\bar{u}_{DC1}$, the received code word $\bar{y}$ is used for generating another decoded information word $\bar{u}_{DC2}$. At first, a modified code word $\bar{m}$ is generated using only the received code word $\bar{y}$. For this, the received code word $\bar{y}$ is cyclically shifted in a shifting step 21 for obtaining a cyclic shifted code word $\bar{y}_c = [y(n), y(1), y(2),..., y(n-1)]$.

Due to the fact, that the applied block code is a cyclic block code, the cyclic shifted code word $\bar{y}_c$ is a valid code word of this block code. Furthermore, the modified code word $\bar{m}$ is obtained, by adding the received code word $\bar{y}$ and the cyclically shifted code word $\bar{y}_c$ in an addition step 22 as

$$\vec{m} = \bar{y} \oplus \bar{y}_c = \left[ y(1) \oplus y(n) \;,\; y(2) \oplus y(1) \;,\; y(3) \oplus y(2) \;,\; \ldots \;,\; y(n) \oplus y(n-1) \right] \;.$$

Since the applied block code is a linear block code, the superposition of the received code word $\bar{y}$ and the cyclically shifted code word $\bar{y}_c$ yields a valid code word $\bar{m}$ of this block code.

Looking at the modified code word $\bar{m}$ in detail, the two steps of cyclically shifting the received code word $\bar{y}$ and then adding it to the code word $\bar{y}_c$ can be interpreted as a step of differentially decoding of the received code word $\bar{y}$, except for the first bit of the yielded code word $\bar{m}$.

Within a step of forward error correction decoding 6", the modified code word $\bar{m}$ is decoded using a decoding algorithm that is suitable for the used block code, in order to generate an intermediate information word $i$. The decoding algorithm performs a correction of errors within the modified code word $\bar{m}$. Since the block code is a systematic block code, the first $k$ bits of the modified code word $\bar{m}$ impose a valid information word. Thus, by comparing the first $k$ bits of the modified code word $\bar{m}$ with the resulting information word $i$, an error word $\bar{e}_2 = i \oplus [m(1),...,m(k)]$ can be obtained. From the error word $\bar{e}_2$ a number of samples NE2 corrected during the decoding of the modified code word $\bar{m}$ can be derived.

As a next step, the previously applied steps of cyclically shifting the received code word $\bar{y}$ and adding the cyclically shifted code word $\bar{y}_c$ to the received code word $\bar{y}$ have to be compensated. As already explained above, these two operations can be interpreted as a step of differentially decoding the code word $\bar{y}$. Therefore, a step that is equivalent to a step of differentially encoding the information word $i$ has to be performed for achieving the demanded compensation.

This compensation is achieved, by calculating over the information word $i$ the cumulative sum in a summation step 23 for yielding the decoded information word $\bar{u}_{DC2}$ as

$$\vec{u}_{DC2} = \left[ i(1) \;,\; i(1) \oplus i(2) \;,\; i(1) \oplus i(2) \oplus i(3) \;,\; \ldots \;,\; i(1) \oplus i(2) \oplus ... \oplus i(k) \right] \;.$$

Using a criterion derived from the numbers of corrected samples or corrected bits NE1, NE2, one of the decoded information words $\bar{u}_{DC1}$, $\bar{u}_{DC2}$ is chosen in a selection step 24. The criterion is to choose that decoded information word $\bar{u}_{DC1}$, $\bar{u}_{DC2}$, for which the corresponding number of corrected samples or bits NE1, NE2 is smallest, as the chosen decoded information word $\bar{u}_{DCC}$. Therefore, the criterion indicates, which decoded information word is more reliable. The criterion is thus a criterion, which aims to minimize an error rate of the chosen decoded information word. In the case, that the two numbers of corrected samples NE 1, NE2 are the same, this criterion leads to choosing either one of the decoded information words $\bar{u}_{DC1}$, $\bar{u}_{DC2}$.

According to a first alternative solution, a first criterion is the number of corrected sample NE1 of the decoded information word $\bar{u}_{DC1}$. In the case, that this first criterion does not exceed a predefined number of corrected samples, the decoded information word $\bar{u}_{DC1}$ is always chosen. Thus, this first criterion achieves a minimum error rote.

According to a second alternative solution, the first criterion described in the first alternative solution is used. Furthermore, only if this first criterion exceeds the predefined number of corrected samples, a second criterion is used in this alternative solution, which is to choose that decoded information word $\bar{u}_{DC1}$, $\bar{u}_{DC2}$, for which the corresponding number of corrected samples NE1, NE2 is smallest, as the chosen decoded information word $\bar{u}_{DCC}$. Therefore, this second criterion indicates, which decoded information word is more likely to be identical to the transmitted one. In other words, the second criterion indicates, which decoded information word is more reliable. This second criterion is thus a criterion, which aims to minimize an error rate of the chosen decoded information word. In the case, that the two numbers of corrected samples NE 1, NE2 are the same, the second criterion leads to choosing either one of the decoded information words $\bar{u}_{DC1}$, $\bar{u}_{DC2}$.

According to a third alternative solution, the first criterion described in the first alternative solution is used. Furthermore, only if this first criterion exceeds a predefined number of corrected samples, then the steps of generating the information word $\bar{u}_{DC2}$ from the received code word $\bar{y}$ are carried out. Furthermore, if the first criterion exceeds the predefined number of corrected samples, a second criterion is used in this alternative solution, which is to choose that decoded information word $\bar{u}_{DC1}$, $\bar{u}_{DC2}$, for which the corresponding number of corrected samples NE1, NE2 is smallest, as the chosen decoded information word $\bar{u}_{DCC}$. Therefore, this second criterion indicates, which decoded information word is more likely identical to the transmitted one. In other words, the second criterion indicates, which decoded information word is more reliable .This second criterion is thus a criterion, which aims to minimize an error rate of the chosen decoded information word. In the case, that the two numbers of errors NE 1, NE2 are the same, the second criterion leads to choosing either one of the decoded information words $\bar{u}_{DC1}$, $\bar{u}_{DC2}$.

The chosen decoded information word $\bar{u}_{DCC}$ is then differentially decoded in a step of differential decoding 12 for obtaining the output bit sequence OBS.

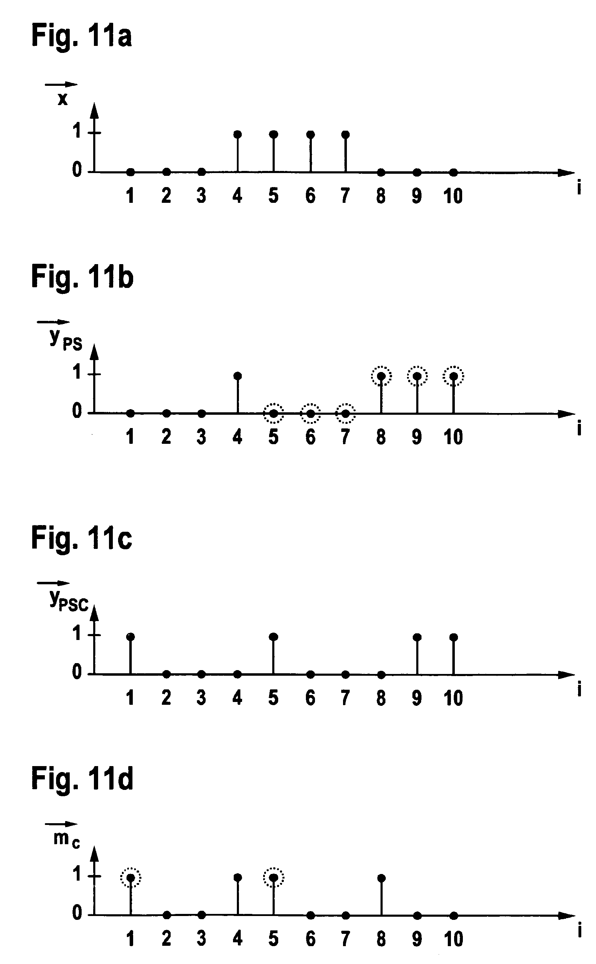

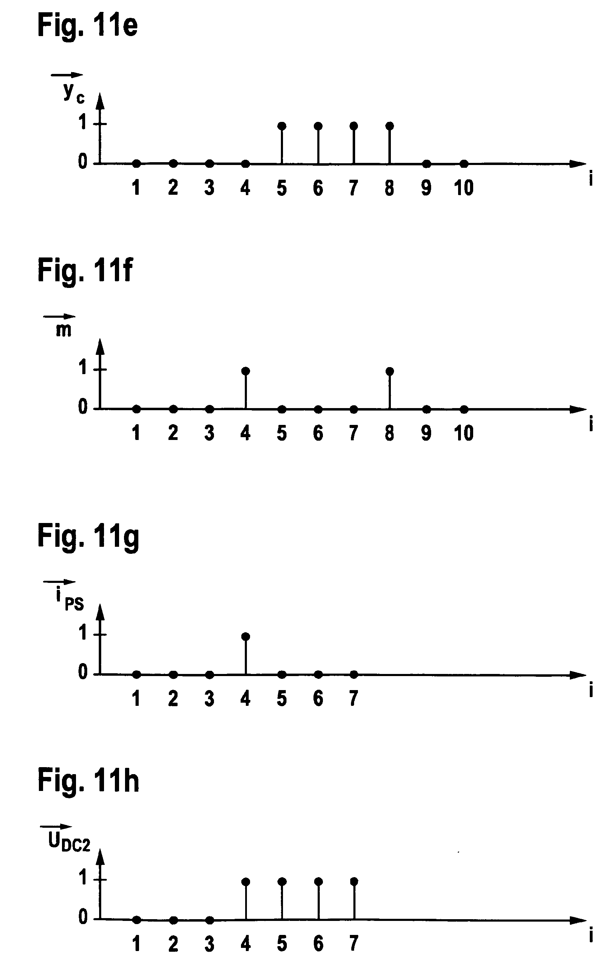

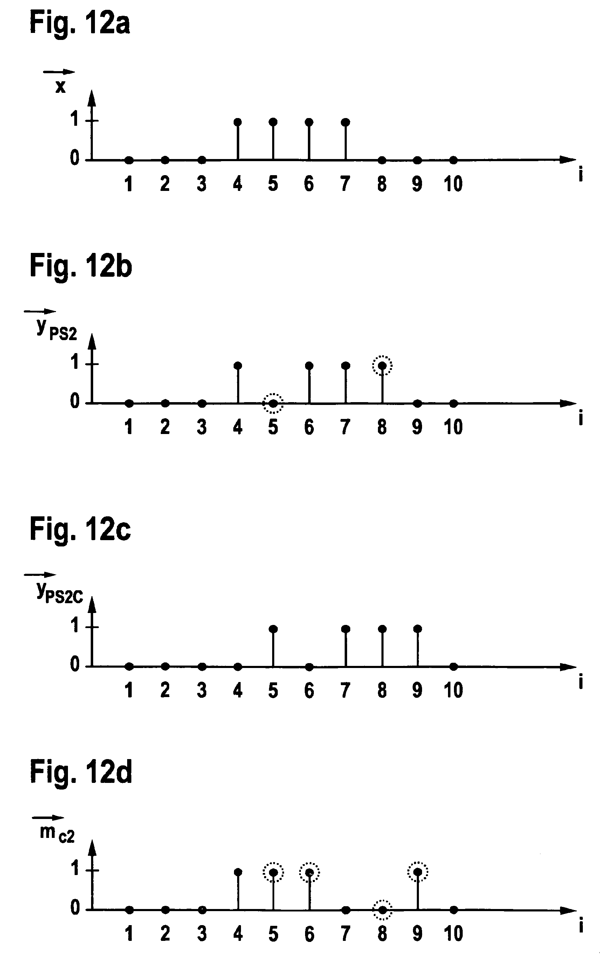

The advantages of the proposed method over the prior art are described in detail using exemplarily code words and information words depicted in the Figures 11 and 12.

Figure 11 shows different code words and information words in the case of a persisting phase slip and in the case of no phase error at all. Figure 11a shows the correct code word $\bar{x}$ that is to be transmitted via the transmission channel. Figure 11 b shows the received code word $\bar{y}_{PS}$ in case of a phase slip starting at the fifth sample and persisting up to the tenth sample. Since the code word $\bar{y}_{PS}$ suffers from six bit errors, it is very likely that the decoding algorithm generating the information word $\bar{u}_{DC1}$ by decoding the code word $\bar{y}_{PS}$ will not be able to correct all of these errors in order to generate a correct information word. Furthermore, the number of samples or bits NE1 corrected by the decoding algorithm will be rather high.

Figure 11c shows the cyclically shifted code word $\bar{y}_{PSC}$, that is generated by cyclically shifting the received code word $\bar{y}_{PS}$. The modified code word $\bar{m}_c$ shown in Figure 11d is obtained from an addition of the code word $\bar{y}_{PS}$ the code word $\bar{y}_{PSC}$. This obtained modified code word $\bar{m}_c$ can be compared to that code word $\bar{m}$, shown in Figure 11f, which would have been obtained in the case that a code word equal to the code word $\bar{x}$ would have been received without any errors. For illustration of the derivation of the correct modified code word $\bar{m}$ of Figure 11f, the cycled code word $\bar{y}_c$ of a correctly received code word $\bar{y}$ is shown in Figure 11 e.

Comparing the generated code word $\bar{m}_c$ and the modified code word $\bar{m}$, one can clearly see, that the modified code word $\bar{m}_c$ contains only two errors, at the first sample and at the fifth sample. In case this modified code word $\bar{m}_c$ is provided to a decoding algorithm, chances are high that the decoding algorithm will be able to correct these two errors and thus generate a correct intermediate information word $i_{PS}$ shown in Figure 11g, which consists of seven bits. The lost three bits of the code words in this example are the redundancy bits added by the block code, meaning that $k = 7$ and $n = 10$.

Calculating from the corrected information word $i_{PS}$ the decoded information word $\bar{u}_{DC2}$, by calculating the cumulative sum of the corrected information word $i_{PS}$, one yields the sequence depicted in Figure 11 h. Since the number of bits corrected during the step of decoding the modified code word $\bar{m}_c$ for generating the intermediate information word $i_{PS}$ will be two corrected samples or bits in comparison to the high number of samples or bits corrected when decoding the code word $\bar{y}_{PS}$ for obtaining the code word $\bar{u}_{DC1}$, the information word $\bar{u}_{DC2}$ will be chosen as the information word $\bar{u}_{DCC}$ and then be forwarded to the block of differentially decoding for obtaining the output bit sequence OBS.

From the example shown in Figure 11 it becomes clear, that although the received erroneous code word $\bar{y}_{PS}$ suffers from six errors due to a persisting phase slip, the proposed method yields a solution, in which these six errors caused by the persistent phase slip can be corrected.

Figure 12 shows different signals occurring in the case of two single bit errors taking place at non consecutive sample. Figure 12a shows the correct code word $\bar{x}$. Figure 12b shows a received erroneous code word $\bar{y}_{PS2}$, which suffers from bit errors at the fifth and the eighth sample, due to two single phase slips occurring at non consecutive samples. Examining the code word $\bar{y}_{PS2}$, one can see that it is very likely that the decoding algorithm decoding the received code word $\bar{y}_{PS2}$ into the information word $\bar{u}_{DC1}$ will be able to correct these two errors and thus obtain a correct information word $\bar{u}_{DC1}$.

Comparing the received erroneous code word $\bar{y}_{PS2}$ to that erroneous bit sequence $\bar{y}''$ shown in Figure 8b received according to the solution of the prior art, one can clearly see that according to the solution of the prior art two single phase slips would eventually lead to four bit errors due to error multiplication. According to the proposed solution, this disadvantageous effect of error multiplication in the case of single errors at non consecutive sample does not take place any more, since only two errors occur in the code word $\bar{y}_{PS2}$ which is provided to the decoding algorithm. Therefore, the proposed solution is less sensitive to errors caused by single errors occurring at non consecutive samples than the solution of the prior art.

For the purpose of illustration, Figure 12c shows the cycled code word $\overline{y}_{PS2C}$, which is obtained by cyclically shifting the received code word $\overline{y}_{PS2}$. The modified code word $\overline{m}_{c2}$ is illustrated in Figure 12d. Comparing this modified code word $\overline{m}_{c2}$ with the correct modified code word $\overline{m}$ of Figure 11f, , one can clearly see that the modified code word $\overline{m}_{c2}$ suffers from four bit errors, at the fifth, sixth, eighth and the ninth sample. These altogether four errors impose a higher challenge for the decoding algorithm trying to generate an intermediate information word by decoding the modified code word $\overline{m}_{c2}$, than the two errors of the code word $\overline{y}_{PS2}$ for generating the information word $\overline{u}_{DC1}$. Therefore, the number of corrected samples or bits when decoding the modified code word $\overline{m}_{c2}$ will be clearly higher than the number of corrected samples or bits when decoding the received code word $\overline{y}_{PS2}$ for obtaining the information word $\overline{u}_{DC1}$. Therefore, in this case of two single phase slips occurring at non consecutive samples, the information word $\overline{u}_{DC1}$ will be chosen as the information word $\overline{u}_{DCC}$, that will then be differentially decoded for obtaining the output bit sequence OBS.

To summarise the above, one can clearly see, that the proposed methods is able to avoid the problem of error multiplication in case of single phase slips occurring at non consecutive samples in contrast to the prior art, whilst at the same time the proposed method is also able to correctly decode a received code word in the case that a persisting phase slip causes a high number of bit errors within the received code word. This has not been achieved according to the solutions of the prior art.

**Second embodiment of the proposed method**

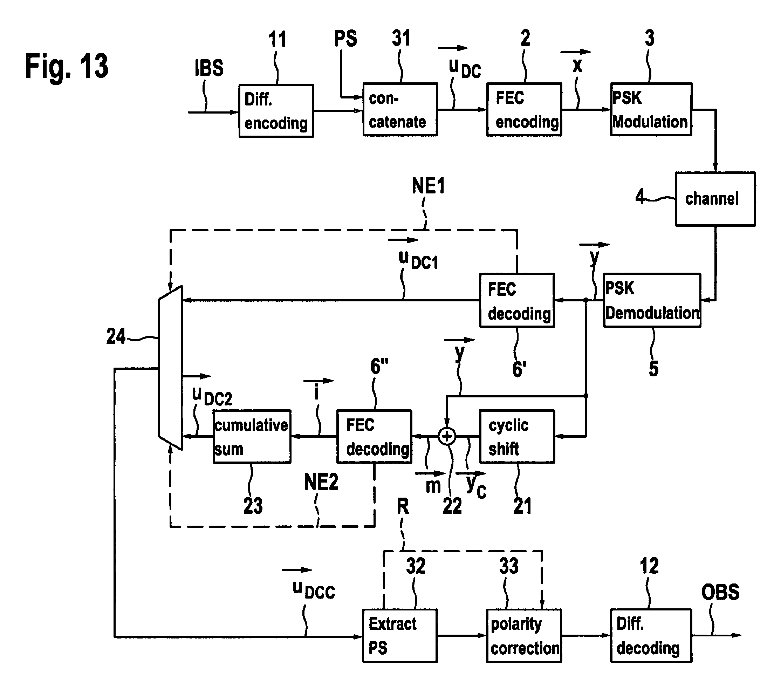

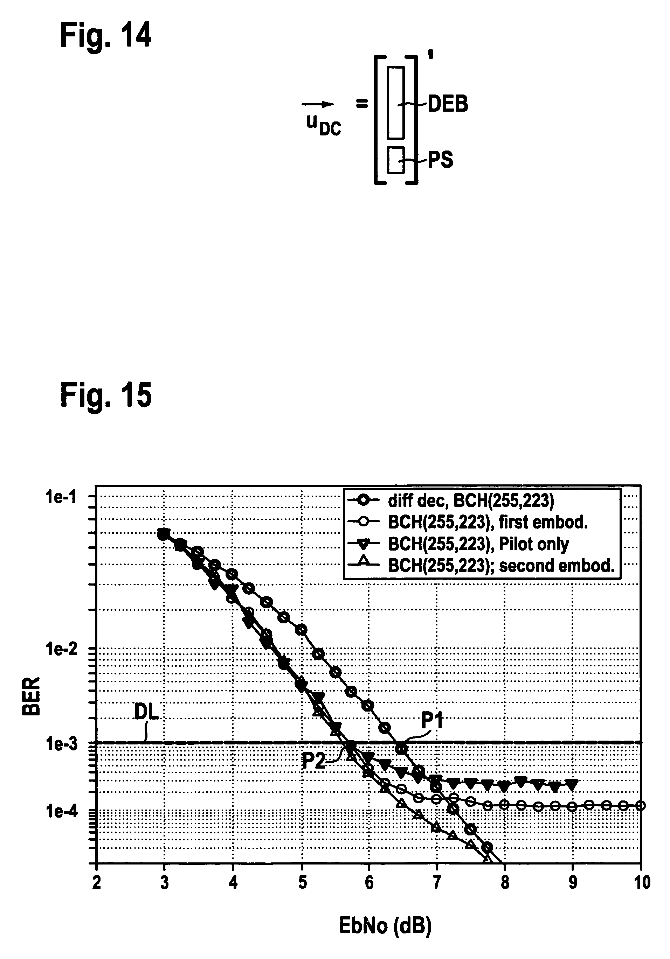

Figure 13 shows a block diagram illustrating the proposed method according to a second embodiment. The block diagram shown in Figure 13 contains all elements shown in the block diagram in Figure 10. In addition, the block diagram in Figure 13 shows a concatenation step 31 located between the step of differential encoding 11 and the step of forward error encoding 2. During this concatenation step 31, the information word $\overline{u}_{DC}$ is generated, by adding to the chosen consecutive number of differentially encoded bits a pilot bit sequence PS. This is furthermore illustrated in Figure 14, where the differentially encoded bits DEB are concatenated with the pilot sequence PS. The pilot sequence consists of a sequence of bits. Thus, this pilot sequence PS becomes a part of the information word $\overline{u}_{DC}$ that is to be encoded by the block code for generating the code word $\overline{x}$.

On the receiving side, the chosen information word $\overline{u}_{DCC}$ is provided to an extraction step 32. During this extraction step 32, that fraction which corresponds in place to the previously inserted pilot bit sequence PS is extracted and removed from the information word $\overline{u}_{DCC}$, such that the information word $\overline{u}_{DCC}$ contains only that fraction which corresponds to the previously chosen consecutive number of bits DEB. The extracted fraction is compared to the pilot bit sequence PS, which has to be known on the receiving side. The pilot bit sequence PS is either stored at the receiving side in a memory device or it has been previously transmitted. The comparison is carried out, by determining the difference between the extracted fraction and the pilot bit sequence. The result R of this comparison is provided to a next step of polarity correction 33. Also, the information word $\overline{u}_{DCC}$, from which the pilot sequence PS has been removed, is provided to the step of polarity correction 33.

In the case that the extracted fraction and the pilot bit sequence PS are identical to each other, such that the resulting difference obtained via a modulo-2 addition yields only zeros, the fraction of the information word $\overline{u}_{DCC}$ corresponding in place to the previously chosen consecutive bits DEB is left unchanged in the step 33. In the case that, the difference exceeds a predefined number of bits having a value equal to '1' thus indicating an error, the information word $\overline{u}_{DCC}$ is inverted in the step 33. This inversion is carried out for compensating a phase slip persisting throughout all bits of the received code word $\overline{y}$. After a possible inversion of the information word $\overline{u}_{DCC}$, the resulting information word is differentially decoded in the step of differential decoding 12, for obtaining the output bit sequence OBS.

Figure 15 shows different bit error rotes BER for different signal to noise ratios EbNo in the case of transmitting data via the different discussed methods when using as a systematic, linear, cyclic block code a BCH code for which $k$ is equal to 223 and n is equal to 255. The probability of a phase slip has been chosen to 1e-4.

The curve indicated by the solid black circles shows the bit error rate BER for the method according to the prior art illustrated in Figure 3. As it has been previously discussed, for optical transmission systems it is desirable to achieve a bit error rate BER that is not higher than 1e-3, which is indicated by the dashed line DL. This is achieved by the method of the prior art for an approximate signal to noise ratio of 6.5 dB, as it can be seen by the error rate indicated in Figure 15 as P1.

The bit error rate resulting from the proposed method according to the first embodiment con be seen in Figure 15 as that curve which is represented by the white circles. As it can be clearly observed, the desirable bit error rate of 1 E-3 is achieved by this proposed method at a signal to noise ratio of approximately 5.8 dB, indicated in Figure 15 as the point P2. Therefore, the first embodiment of the proposed method achieves the some desirable bit error rate at a signal to noise ratio that is approximately 0.8 dB lower than the signal to noise ratio needed for the method according to the prior art. Thus, the method according to the first embodiment achieves a clear advantage over the prior art.

Furthermore, the bit error rate resulting from the method according to the second embodiment is indicated as a curve with white triangles. This method of the second embodiment achieves the desirable bit error rate of 1 E-3 also approximately at the same signal to noise ratio EbN0 of 5.8 dB as the method according to the first embodiment. Furthermore, the method proposed according to the second embodiment achieves at any signal to noise ratio EbN0 a bit error rate BER which is smaller than the bit error rate achieved by the method according to the prior art. Therefore the method according to the second embodiment clearly is of advantage in comparison to the method of the prior art.

For illustration purposes, the curve represented by the black triangles shows the bit error rate in case of using the pilot bit sequence of the second embodiment, but always directly generating the decoded information word from the received code word as shown in the upper branch of the receiving side in Figure 10. One can clearly see, that also generating another decoded information word as shown in the lower branch of the receiving side in Figure 10, and then choosing one of the decoded information words in dependence on the detected errors give a clear advantage of a method using only the pilot bit sequence.

The proposed method according to both embodiments achieve the desirable bit error rate of 1E-3 at a signal to noise ratio which is definitely lower than that needed for achieving the same desirable bit rote when using the method known according to the prior art. Therefore, the physical span of the transmission channel con be longer and signal regeneration does not have to be performed as early as when using the method of the prior art.

**Embodiment of a receiving device**

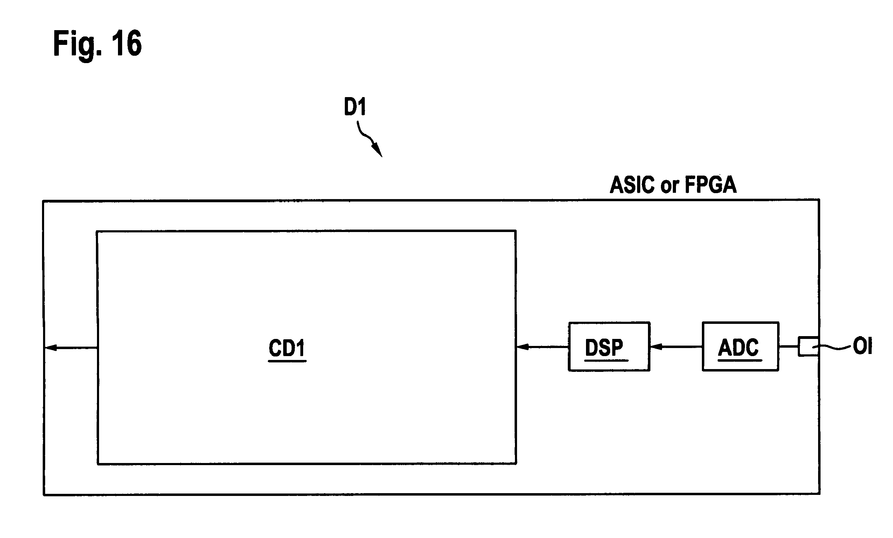

Figure 16 shows a block diagram of a proposed embodiment of a receiving device.

The device D1 contains an optical interface OI for receiving on optical signal. To the optical interface OI, a bank of analogue digital converters ADC is connected, which is adapted to convert the optical signal into a set of digital samples. These samples are then passed on to a digital signal processing device DSP, which is adapted to generate from the set of samples a received code word. For this purpose, the digital signal processing device DSP processes the signal to undo impairments the signal experienced while propagation through the channel and applies a hard decision detection scheme as previously described above.

The device D1 contains at least one calculation device CD1, which is adapted to generate a decoded information word as well as a number of corrected samples or bits, by applying to the received code word a decoding algorithm in accordance to a systematic, linear, cyclic block code. The calculation device CD1 is furthermore adapted to generate a modified code word based on only the received code word. Furthermore, the calculation device CD1 is adapted to generate an intermediate information word and a number of corrected samples or bits by applying to the modifying code word a decoding algorithm in accordance to the above mentioned block code. Furthermore, the calculation device CD1 is adapted to generate a decoded information word based on the intermediate information word, and to choose one of the decoded information words in dependence on the detected numbers of corrected samples or bits.

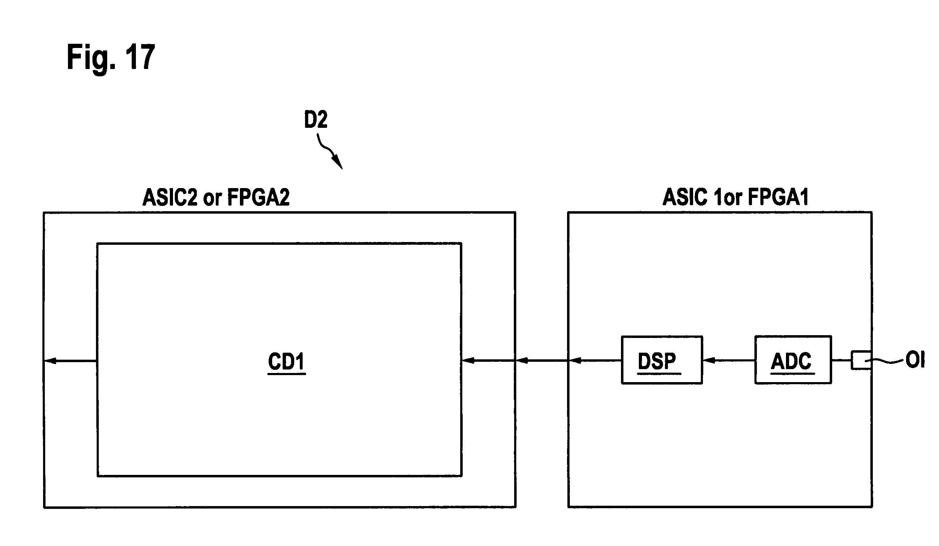

The calculation device CD1 is adapted to generate an output bit sequence, by differentially decoding the chosen decoded information word. Preferably, the analogue digital converting devices ADC, the digital signal processing device and the calculation device CD1 are sub elements of the device D1 being formed by an application specific integrated circuit ASIC or a field programmable gate array FPGA. According to on alternative solution shown in Figure 17, the analogue digital converting devices ADC and the digital signal processing device are formed on a first application specific integrated circuit ASIC1 or a first field programmable gate array FPGA1, while the at least one calculation device CD1 is formed on a second, separate application specific integrated circuit ASIC2 or a second field programmable gate array FPGA2.

The proposed receiving devices of the alternative solutions shown in Figure 16 and Figure 17 are each adapted to carry out the different steps of the proposed methods described above.

**Claims**

1.  Method of transmitting data via an optical transmission channel,
    comprising the steps of

> a) generating an input information word ($\bar{u}$), by differentially encoding an input bit sequence (IBS),
> b) generating an input code word ($\bar{x}$), by applying a systematic, linear, cyclic block code to said input information word ($\bar{u}$),
> c) modulating said input code word ($\bar{x}$) onto an optical carrier signal using a phase-shift keying modulation scheme, transmitting said modulated signal via an optical transmission channel, receiving said transmitted signal, deriving from said received signal a received code word ($\bar{y}$),
> d) generating a first decoded information word ($\bar{u}_{DC1}$) and a first number of corrected samples (NE1), by applying to said received code word ($\bar{y}$) a decoding algorithm suitable for said block code,

e) generating a modified code word ($\overline{m}$) using said received code word ($\overline{y}$),

f) generating an intermediate information word ($i$) and a second number of corrected samples (NE2), by applying to said modified code word ($\overline{m}$) a decoding algorithm suitable for said block code, and generating a second decoded information word ($\overline{u}_{DC2}$) using said intermediate information word ($i$),

g) choosing one of said first or said second decoded information words ($\overline{u}_{DC1}$, $\overline{u}_{DC2}$) using a criterion derived from said numbers of corrected samples (NE1, NE2),

h) generating an output bit sequence (OBS), by differentially decoding said chosen decoded information word ($\overline{u}_{DCC}$)

wherein in said step e) said modified code word is generated by

- a cyclic shift of said received code word ($\overline{y}$) and
- an addition of said cyclically shifted code word ($\overline{y}_c$) and said received code word ($\overline{y}$), and

wherein in said step f) said second decoded information word ($\overline{u}_{DC2}$) is generated by computing a cumulative sum of said intermediate information word ($i$).

2. Method according to claim 1,
   wherein said phase-shift keying modulation scheme is a binary phase shift keying modulation scheme.

3. Method according to any of the claims 1 to 2,
   wherein in said step c) said received code word ($\overline{y}$) is derived, by applying a hard decision detection scheme to said received signal.

4. Method according to any of the claims 1 to 3,
   wherein in said step a) said input information word ($\overline{u}$) is generated, by choosing a number of consecutive differentially encoded bits (DEB).

5. Method according to any of the claims 1 to 4,
   wherein in said steps a) and h) said differential encoding and said differential decoding are performed based on a modulo-2 addition.

6. Method according to any of the claims 4 or 5,
   wherein said step a) comprises the sub-step of

   - concatenating said chosen number of consecutive differentially encoded bits (DEB) with a pilot bit sequence (PS),

   and wherein said step g) comprises the sub-steps of

   - extracting from said chosen decoded information word ($\overline{u}_{DCC}$) a fraction corresponding in place to said pilot bit sequence (PS),
   - determining a difference between said extracted fraction and said pilot bit sequence (PS),
   - inverting said chosen decoded information word ($\overline{u}_{DCC}$) in dependence on said determined difference.

7. Device (D1) for receiving data via an optical signal,
   comprising
   an optical interface (OI) adapted to receive an optical phase modulated signal,
   at least one analogue-digital-converting device (ADC) adapted to convert said received signal into a set of digital samples,
   a digital signal processing device (DSP) adapted to derive from said set of samples a received code word ($\overline{y}$),
   at least one calculation device (CD1) adapted to

   - generate a first decoded information word ($\overline{u}_{DC1}$) and a first number of corrected samples (NE1), by applying to said received code ($\overline{y}$) word a decoding algorithm suitable for a systematic, linear, cyclic block code,
   - generate a modified code word ($\overline{m}$) using said received code word ($\overline{y}$), by

     o a cyclic shift of said received code word ($\overline{y}$) and

o an addition of said cyclically shifted code word ($\overline{y}_c$) and said received code word ($\overline{y}$),

- generate an intermediate information word ($i$) and a second number of corrected samples (NE2), by applying to said modified code word ($\overline{m}$) a decoding algorithm using said block code,
- generate a second decoded information word ($\overline{u}_{DC2}$) using said intermediate information word ($i$), by computing a cumulative sum of said intermediate information word ($i$),
- choose one of said decoded information words ($\overline{u}_{DC1}$, $\overline{u}_{DC2}$) using a criterion derived from said numbers of corrected samples,
- generate an output bit sequence (OBS), by differentially decoding said chosen decoded information word ($\overline{u}_{DCC}$).

**Patentansprüche**

1. Verfahren zum Übertragen von Daten über einen optischen Übertragungskanal, die folgenden Schritte umfassend:

a) Erzeugen eines Eingangs-Informationswort ($\overline{u}$) durch differenzielles Codieren einer Eingangs-Bitfolge (IBS),
b) Erzeugen eines Eingangs-Codeworts ($\overline{x}$) durch Anwenden eines systematischen, linearen, zyklischen Blockcodes auf das besagte Eingangs-Informationswort ($\overline{u}$),
c) Modulieren des besagten Eingangs-Codeworts ($\overline{x}$) auf ein optisches Trägersignal unter Verwendung eines Phasenumtastungs-Modulationsschemas, übertragen des besagten modulierten Signals über einen optischen Übertragungskanal, Empfangen des besagten übertragenen Signals, Ableiten eines empfangenen Codeworts ($\overline{y}$) aus dem besagten empfangenen Signal,
d) Erzeugen eines ersten decodierten Informationsworts ($\overline{u}_{DC1}$) und einer ersten Anzahl von korrigierten Abtastwerten (NE1) durch Anwenden eines für den besagten Blockcode geeigneten Decodierungsalgorithmus auf das besagte empfangene Codewort ($\overline{y}$),
e) Erzeugen eines modifizierten Codeworts ($\overline{m}$) unter Verwendung des besagten empfangenen Codeworts ($\overline{y}$),
f) Erzeugen eines Zwischeninformationsworts ($i$) und einer zweiten Anzahl von korrigierten Abtastwerten (NE2) durch Anwenden eines für den besagten Blockcode geeigneten Decodierungsalgorithmus auf das besagte modifizierte Codewort ($\overline{m}$), und Erzeugen eines zweiten decodierten Informationsworts ($\overline{u}_{DC2}$) unter Verwendung des besagten Zwischeninformationsworts ($i$),
g) Auswählen entweder des besagten ersten oder des besagten zweiten decodierten Informationswort ($\overline{u}_{DC1}$, $\overline{u}_{DC2}$) unter Verwendung eines aus den besagten Anzahlen von korrigierten Abtastwerten (NE1, NE2) abgeleiteten Kriteriums,
h) Erzeugen einer Ausgangs-Bitfolge (OBS) durch differenzielles Decodieren des besagten ausgewählten decodierten Informationsworts ($\overline{u}_{DCC}$),

wobei, in dem besagten Schritt e), das besagte modifizierte Codewort erzeugt wird durch

- eine zyklische Verschiebung des besagten empfangenen Codeworts ($\overline{y}$), und
- ein Addieren des besagten zyklisch verschobenen Codeworts ($\overline{y}_c$) und des besagten empfangenen Codewort ($\overline{y}$), und

wobei, in dem besagten Schritt f), das besagte zweite decodierte Informationswort ($\overline{u}_{DC2}$) durch Berechnen einer kumulativen Summe des besagten Zwischeninformationsworts ($i$) erzeugt wird.

2. Verfahren nach Anspruch 1,
wobei das besagte Phasenumtastungs-Modulationsschema ein binäres Phasenumtastungs-Modulationsschema ist.

3. Verfahren nach einem beliebigen der Ansprüche 1 bis 2,
wobei, in dem besagten Schritt c), das besagte empfangene Codewort ($\overline{y}$) durch Anwenden eines Hartentscheidungsdetektionsschemas auf das besagte empfangene Signal abgeleitet wird.

4. Verfahren nach einem beliebigen der Ansprüche 1 bis 3,
wobei, in dem besagten Schritt a), das besagte Eingangs-Informationswort ($\overline{u}$) durch Auswählen einer Anzahl von aufeinanderfolgenden differenziell codierten Bits (DEB) erzeugt wird.

**5.** Verfahren nach einem beliebigen der Ansprüche 1 bis 4,
wobei, in den besagten Schritten a) und h), das besagte differenzielle Codieren und das besagte differenzielle Decodieren auf der Basis einer Modulo-2-Addition durchgeführt wird.

**6.** Verfahren nach einem beliebigen der Ansprüche 4 oder 5,
wobei der besagte Schritt a) den folgenden Teilschritt umfasst:

- Verketten der besagten ausgewählten Anzahl von aufeinanderfolgenden differenziell codierten Bits (DEB) mit einer Pilot-Bitfolge (PS),

und wobei der besagte Schritt g) die folgenden Teilschritte umfasst:

- Extrahieren, aus dem besagten ausgewählten decodierten Informationswort ($\overline{u}_{DCC}$), eines Bruchteils, welche hier der besagten Pilot-Bitfolge (PS) entspricht,
- Ermitteln einer Differenz zwischen dem besagten extrahierten Bruchteil und der besagten Pilot-Bitfolge (PS),
- Invertieren des besagten ausgewählten decodierten Informationsworts ($\overline{u}_{DCC}$) in Abhängigkeit von der besagten ermittelten Differenz.

**7.** Vorrichtung (D1) für den Empfang von Daten über ein optisches Signal, umfassend:

Eine optische Schnittstelle (OI), ausgelegt für den Empfang eines phasenmodulierten optischen Signals,
mindestens eine Vorrichtung zur Analog/Digital-Umwandlung (ADC), ausgelegt für das Umwandeln des besagten empfangenen Signals in einen Satz von digitalen Abtastwerten,
eine digitale Signalverarbeitungsvorrichtung (DSP), ausgelegt für das Ableiten eines empfangenen Codeworts ($\overline{y}$) aus dem besagten Satz von Abtastwerten,
mindestens eine Berechnungsvorrichtung (CD1), ausgelegt für das Durchführen der folgenden Schritte:

- Erzeugen eines ersten decodierten Informationsworts ($\overline{u}_{DC1}$) und einer ersten Anzahl von korrigierten Abtastwerten (NE1) durch Anwenden eines für einen systematischen, linearen, zyklischen Blockcode geeigneten Decodierungsagorithmus auf das besagte empfangene Codewort ($\overline{y}$),
- Erzeugen eines modifizierten Codeworts ($\overline{m}$) unter Verwendung des besagten empfangenen Codeworts ($\overline{y}$), durch

○ eine zyklische Verschiebung des besagten empfangenen Codeworts ($\overline{y}$) und
○ Addieren des besagten zyklisch verschobenen Codeworts ($\overline{y}_c$) und des besagten empfangenen Codeworts ($\overline{y}$),

- Erzeugen eines Zwischeninformationsworts ($i$) und einer zweiten Anzahl von korrigierten Abtastwerten (NE2) durch Anwenden eines Decodierungsalgorithmus auf das besagte modifizierte Codewort ($\overline{m}$) unter Verwendung des besagten Blockcodes,
- Erzeugen eines zweiten decodierten Informationsworts ($\overline{u}_{DC2}$) unter Verwendung des besagten Zwischeninformationsworts ($i$), durch Berechnen einer kumulativen Summe des besagten Zwischeninformationsworts ($i$),
- Auswählen eines der besagten decodierten Informatiotiswörter ($\overline{u}_{DC1}$, $\overline{u}_{DC2}$) unter Verwendung eines aus den besagten Anzahlen von korrigierten Abtastwerten abgeleiteten Kriteriums,
- Erzeugen einer Ausgangs-Bitfolge (OBS) durch differenzielles Decodieren des besagten ausgewählten decodierten Informationsworts ($\overline{u}_{DCC}$).

## Revendications

**1.** Procédé de transmission de données par l'intermédiaire d'un canal de transmission optique, comprenant les étapes suivantes :

a) générer un mot d'information d'entrée ($\overline{u}$), par codage différentiel d'une séquence de bits d'entrée (IBS),
b) générer un mot code d'entrée ($\overline{x}$) en appliquant un code de bloc cyclique systématique et linéaire audit mot d'information d'entrée ($\overline{u}$),
c) moduler ledit mot code d'entrée ($\overline{x}$) sur un signal de porteuse optique en utilisant un schéma de modulation par déplacement de phase, transmettre ledit signal modulé par l'intermédiaire d'un canal de transmission optique, recevoir ledit signal transmis, dériver à partir dudit signal reçu un mot code reçu ($\bar{y}$),

d) générer un premier mot d'information décodé ($\bar{u}_{DC1}$) et un premier nombre d'échantillons corrigés (NE1), en appliquant audit mot code reçu ($\bar{y}$) un algorithme de décodage adapté audit code de bloc,

e) générer un mot code modifié ($\bar{m}$) en utilisant ledit mot code reçu ($\bar{y}$),

f) générer un mot d'information intermédiaire ($i$) et un deuxième nombre d'échantillons corrigés (NE2), en appliquant audit mot code modifié ($\bar{m}$), un algorithme de décodage adapté audit code de bloc, et générer un deuxième mot d'information décodé ($\bar{u}_{DC2}$) en utilisant ledit mot d'information intermédiaire ($i$),

g) choisir un parmi lesdits premier et deuxième mots d'information décodés ($\bar{u}_{DC1}$, $\bar{u}_{DC2}$) en utilisant un critère dérivé à partir desdits nombres d'échantillons corrigés (NE1, NE2),

h) générer une séquence de bits de sortie (OBS), par décodage différentiel dudit mot d'information décodé ($\bar{u}_{DCC}$) choisi,

dans lequel dans ladite étape e) ledit mot de code modifié est généré par

- un décalage cyclique dudit mot code reçu ($\bar{y}$), et
- une addition dudit mot code ($\bar{y}_c$) à décalage cyclique et dudit mot code reçu ($\bar{y}$), et

dans lequel dans ladite étape f) ledit deuxième mot d'information décodé ($\bar{u}_{DC2}$) est généré en calculant une somme cumulée dudit mot d'information intermédiaire ($i$).

2. Procédé selon la revendication 1,
dans lequel ledit schéma de modulation par déplacement de phase est un schéma de modulation par déplacement de phase binaire.

3. Procédé selon l'une quelconque des revendications 1 à 2,
dans lequel dans ladite étape c) ledit mot code reçu ($\bar{y}$) est dérivé, en appliquant un schéma de détection d'une décision ferme audit signal reçu.

4. Procédé selon l'une quelconque des revendications 1 à 3,
dans lequel dans ladite étape a) ledit mot d'information d'entrée ($\bar{u}$) est généré, en choisissant un nombre de bits codés différentiellement (DEB) consécutifs.

5. Procédé selon l'une quelconque des revendications 1 à 4,
dans lequel dans lesdites étapes a) et h) ledit codage différentiel et ledit décodage différentiel sont exécutés sur la base d'une addition modulo-2.

6. Procédé selon l'une quelconque des revendications 4 ou 5,
dans lequel ladite étape a) comprend la sous-étape de :

- concaténation dudit nombre choisi de bits codés différentiellement (DEB) consécutifs avec une séquence de bits pilotes (PS),

et dans lequel ladite étape g) comprend les sous-étapes suivantes :

- extraire, à partir dudit mot d'information décodé ($\bar{u}_{DCC}$) choisi, une fraction correspondant en place à ladite séquence de bits pilotes (PS),
- déterminer une différence entre ladite fraction extraite et ladite séquence de bits pilotes (PS),
- inverser ledit mot d'information décodé ($\bar{u}_{DCC}$) choisi en fonction de ladite différence déterminée.

7. Dispositif (D1) pour recevoir des données par l'intermédiaire d'un signal optique, comprenant :

une interface optique (OI) adaptée pour recevoir un signal optique modulé en phase,
au moins un dispositif de conversion analogique-numérique (ADC) adapté pour convertir ledit signal reçu en un ensemble d'échantillons numériques,
un dispositif de traitement de signaux numériques (DSP) adapté pour dériver dudit ensemble d'échantillons un mot code reçu ($\bar{y}$),
au moins un dispositif de calcul (CD1) adapté pour :

- générer un premier mot d'information décodé ($\overline{u}_{DC1}$) et un premier nombre d'échantillons corrigés (NE1), en appliquant audit mot code reçu ($\overline{y}$) un algorithme de décodage adapté à un code de bloc cyclique systématique et linéaire,
- générer un mot code modifié ($\overline{m}$) en utilisant ledit mot code reçu ($\overline{y}$), par

    o un décalage cyclique dudit mot code reçu ($\overline{y}$)
    et
    o une addition dudit mot code ($\overline{y}_c$) à décalage cyclique et dudit mot code reçu ($\overline{y}$),

- générer un mot d'information intermédiaire ($i$) et un deuxième nombre d'échantillons corrigés (NE2), en appliquant audit mot code modifié ($\overline{m}$) un algorithme de décodage en utilisant ledit code de bloc,
- générer un deuxième mot d'information décodé ($\overline{u}_{DC2}$) en utilisant ledit mot d'information intermédiaire ($i$), en calculant une somme cumulée dudit mot d'information intermédiaire ($i$),
- choisir un desdits mots d'information décodés ($\overline{u}_{DC1}$, $\overline{u}_{DC2}$) en utilisant un critère dérivé desdits nombres d'échantillons corrigés,
- générer une séquence de bits de sortie (OBS), par décodage différentiel dudit mot d'information décodé ($\overline{u}_{DCC}$) choisi.

## Fig. 1

EP 2 403 167 B1

# Fig. 2

**Fig. 3**

IBS → | **Splitting** (1) | →$\overrightarrow{u}$→ | **FEC encoding** (2) | →$\overrightarrow{x}$→ | **Differential encoding** (11) | →$\overrightarrow{x}_{DC}$→ | **PSK Modulation** (3) |

| **channel** (4) |

OBS ← | **Concate-nation** (7) | ←$\overrightarrow{u'}$← | **FEC decoding** (6) | ←$\overrightarrow{y}$← | **Differential decoding** (12) | ←$\overrightarrow{y}_{DC}$← | **PSK Demodulation** (5) |

EP 2 403 167 B1

## Fig. 4

## Fig. 5

# Fig. 6a

# Fig. 6b

# Fig. 6c

# Fig. 7a

# Fig. 7b

# Fig. 8a

# Fig. 8b

Fig. 9

## Fig. 10

EP 2 403 167 B1

**Fig. 11a**

**Fig. 11b**

**Fig. 11c**

**Fig. 11d**

## Fig. 11e

## Fig. 11f

## Fig. 11g

## Fig. 11h

# Fig. 12a

# Fig. 12b

# Fig. 12c

# Fig. 12d

## Fig. 13

EP 2 403 167 B1

# Fig. 14

$$\overrightarrow{u_{DC}} = \begin{bmatrix} \boxed{\phantom{DEB}} & \text{—DEB} \\ \boxed{\phantom{PS}} & \text{—PS} \end{bmatrix}$$

# Fig. 15

# Fig. 16

ASIC or FPGA

D1

OI

ADC

DSP

CD1

Fig. 17